# EUROPÄISCHE PATENTANMELDUNG

(11) **EP 2 713 394 A1**
(43) Veröffentlichungstag der Anmeldung: **02.04.2014**
(21) Anmeldenummer: 13178906.7
(22) Anmeldetag: 01.08.2013
(51) Int. Cl.: H01L 23/48, H01L 25/07, H02M 7/487, H02M 7/00

(54) **3-Level-Stromrichterhalbbrücke**

(30) Priorität: 01.10.2012 DE 102012217905
(71) Anmelder: SEMIKRON Elektronik GmbH & Co. KG, 90431 Nürnberg (DE)
(72) Erfinder: Staudt, Ingo, 90439 Nürnberg (DE); Wintrich, Arendt, 90766 Fürth (DE)

(57) **Zusammenfassung**

Die Erfindung betrifft ein 3-Level-Stromrichterhalbbrücke mit einem ersten Substrat (2) und einem vom ersten Substrat (2) getrennt angeordneten zweiten Substrat (3), wobei das erste Substrat (2) einen ersten Isolierstoffkörper (6a) und eine auf dem ersten Isolierstoffkörper (6a) angeordnete elektrisch leitende strukturierte erste Leitungsschicht (7a) aufweist, wobei auf der strukturierten ersten Leitungsschicht (7a) ein erster Leistungshalbleiterschalter (T1), ein zweiter Leistungshalbleiterschalter (T2), eine erste Diode (D1) und eine erste Diodenanordnung (10) angeordnet sind und mit der strukturierten ersten Leitungsschicht (7a) verbunden sind,
wobei das zweite Substrat (3) einen zweiten Isolierstoffkörper (6b) und eine auf dem zweiten Isolierstoffkörper (6b) angeordnete elektrisch leitende strukturierte zweite Leitungsschicht (7b) aufweist,
wobei auf der strukturierten zweiten Leitungsschicht (7b) ein dritter Leistungshalbleiterschalter (T3), ein vierter Leistungshalbleiterschalter (T4), eine zweite Diode (D2) und eine zweite Diodenanordnung (11) angeordnet sind und mit der strukturierten zweiten Leitungsschicht (7b) verbunden sind.

Die Erfindung schafft einen 3-Level Stromrichterhalbbrücke (1,1') mit reduzierten Schaltüberspannungen.

## Beschreibung

Die Erfindung betrifft eine 3-Level-Stromrichterhalbbrücke.

Ein 3-Level-Stromrichter zeichnet sich gegenüber den weit verbreiteten konventionellen Stromrichtern dadurch aus, dass er, wenn er als Wechselrichter betrieben wird, an seinen wechselspannungsseitigen Lastanschlüssen AC nicht nur wie ein konventioneller Stromrichter eine elektrische Wechselspannung erzeugen kann, deren Spannungswert im Wesentlichen der elektrischen positiven oder negativen elektrischen Spannung der Zwischenkreisspannung Ud entspricht, sondern zusätzlich am wechselspannungsseitigen Lastanschluss AC eine elektrische Spannung erzeugen kann, deren Spannungswert im Wesentlichen der halben elektrischen positiven oder negativen Spannung der Zwischenkreisspannung Ud entspricht.

Hierdurch ist z.B. eine bessere Annährung der von Stromrichter am wechselspannungsseitigen Lastanschluss AC erzeugten Spannung an eine sinusförmige Wechselspannung möglich.

Ein 3-Level-Stromrichter weist dabei mehrere 3-Level-Stromrichterhalbbrücken auf, die zur Realisierung eines 3-Level Stromrichters elektrisch miteinander verschalten sind.

Es ist bei 3-Level-Stromrichtern bekannt alle zur Realisierung eines 3-Level-Stromrichters benötigen Leistungshalbleiterschalter und Dioden auf einem einzelnen

Substrat anzuordnen und mittels einer Leiterschicht des Substrats und Bonddrähten miteinander elektrisch leitend zu verbinden. Die realisierbare elektrische Leistung eines 3-Level-Stromrichters bei dem alle zur Realisierung des 3-Level-Stromrichters benötigen Leistungshalbleiterschalter und Dioden auf einem einzelnen Substrat angeordnet sind, ist jedoch, infolge der begrenzten Wärmeableitfähigkeit des einzelnen Substrat, begrenzt.

Weiterhin ist es auch bekannt zur Realisierung von 3-Level-Stromrichtern, insbesondere zur Realisierung von 3-Level-Stromrichtern, welche eine große elektrische Leistung aufweisen, die Leistungshalbleiterschalter und Dioden auf mehreren voneinander getrennten Substraten anzuordnen und die Substrate elektrisch leitend, z.B. mittels elektrischer Leitungen, miteinander zu verbinden. Die auf den Substraten angeordneten Leistungshalbleiterschalter und die Dioden sind dabei elektrisch zu mehreren sogenannten Halbbrückenschaltungen verschalten, die üblicherweise zum Gleich- und Wechselrichten von elektrischen Spannungen und Strömen verwendet werden. Die Substrate sind in der Regel direkt oder indirekt mit einem Kühlkörper verbunden. Die elektrischen Leitungen mit denen die Substrate verbunden sind weisen den Nachteil auf, dass diese eine relativ hohe parasitäre Induktivität aufweisen, was bei Kommutierungsvorgängen hohe Schaltüberspannungen zur Folge hat, die die realisierbare Schaltgeschwindigkeit und Schaltfrequenz der Leistungshalbleiterschalter vermindern.

Die Leistungshalbleiterschalter liegen im Allgemeinen in Form von Transistoren, wie z.B. IGBTs (Insulated Gate Bipolar Transistor) oder MOSFETs (Metal Oxide Semiconductor Field Effect Transistor), oder in Form von gesteuert ausschaltbaren Thyristoren vor.

Aus der EP 1 670 131 A2 ist ein Leistungshalbleitermodul mit verringerten parasitären Induktivitäten bekannt.

Es ist Aufgabe der Erfindung eine 3-Level-Stromrichterhalbbrücke mit reduzierten Schaltüberspannungen zu schaffen.

Diese Aufgabe wird gelöst durch eine 3-Level-Stromrichterhalbbrücke mit einem ersten Substrat und einem vom ersten Substrat getrennt angeordneten zweiten Substrat,
wobei das erste Substrat einen ersten Isolierstoffkörper und eine auf dem ersten Isolierstoffkörper angeordnete elektrisch leitende strukturierte erste Leitungsschicht aufweist, wobei auf der strukturierten ersten Leitungsschicht ein erster Leistungshalbleiterschalter, ein zweiter Leistungshalbleiterschalter, eine erste Diode und eine erste Diodenanordnung angeordnet sind und mit der strukturierten ersten Leitungsschicht verbunden sind,
wobei das zweite Substrat einen zweiten Isolierstoffkörper und eine auf dem zweiten Isolierstoffkörper angeordnete elektrisch leitende strukturierte zweite Leitungsschicht aufweist,
wobei auf der strukturierten zweiten Leitungsschicht ein dritter Leistungshalbleiterschalter, ein vierter Leistungshalbleiterschalter, eine zweite Diode und eine zweite Diodenanordnung angeordnet sind und mit der strukturierten zweiten Leitungsschicht verbunden sind,
wobei ein zweiter Laststromanschluss des ersten Leistungshalbleiterschalters mit einem ersten Laststromanschluss des zweiten Leistungshalbleiterschalter elektrisch leitend verbunden ist,
wobei ein erster Laststromanschluss des vierten Leistungshalbleiterschalters mit einem zweiten Laststromanschluss des dritten Leistungshalbleiterschalter elektrisch leitend verbunden ist,
wobei die Kathode der ersten Diode mit dem zweiten Laststromanschluss des ersten Leistungshalbleiterschalters elektrisch leitend verbunden ist,
wobei die Anode der zweiten Diode mit dem zweiten Laststromanschluss des dritten Leistungshalbleiterschalters elektrisch leitend verbunden ist,
wobei der zweiter Laststromanschluss des zweiten Leistungshalbleiterschalters mit einem Kathodenanschluss der ersten Diodenanordnung elektrisch leitend verbunden ist,
wobei der erste Laststromanschluss des dritten Leistungshalbleiterschalters mit einem Anodenanschluss der zweiten Diodenanordnung elektrisch leitend verbunden ist, wobei der erste Laststromanschluss des ersten Leistungshalbleiterschalters mit einem Kathodenanschluss der zweiten Diodenanordnung elektrisch leitend verbunden ist, wobei der zweite Laststromanschluss des vierten Leistungshalbleiterschalters mit einem Anodenanschluss der ersten Diodenanordnung elektrisch leitend verbunden ist, wobei die Anode der ersten Diode mit der Kathode der zweiten Diode elektrisch leitend verbunden ist,
wobei der zweite Laststromanschluss des zweiten Leistungshalbleiterschalters mit dem ersten Laststromanschluss des dritten Leistungshalbleiterschalters elektrisch leitend verbunden ist.

Vorteilhafte Ausbildungen der Erfindung ergeben sich aus den abhängigen Ansprüchen.

Es erweist sich als vorteilhaft, wenn die erste Diodenanordnung eine fünfte und eine sechse Diode aufweist, wobei die Kathode der sechsten Diode mit der Anode der fünften Diode elektrisch leitend verbunden ist und die zweite Diodenanordnung eine dritte und eine vierte Diode aufweist, wobei die Kathode der vierten Diode mit der Anode der dritten Diode elektrisch leitend verbunden ist. Diese Maßnahme erlaubt die Verwendung von Dioden mit gleicher Sperrspannung für alle Dioden der 3-Level-Stromrichterhalbbrücke.

Weiterhin erweist es sich als vorteilhaft, wenn die Kathode der ersten Diode mit der Kathode der vierten Diode nicht elektrisch leitend verbunden ist und die Kathode der sechsten Diode mit der Anode der zweiten Diode nicht elektrisch leitend verbunden ist, da hierdurch die 3-Level-Stromrichterhalbbrücke einfacher aufgebaut werden kann.

Ferner erweist es sich als vorteilhaft, wenn die erste Diodenanordnung in Form einer einzelnen Diode ausgebildet ist und die zweite Diodenanordnung in Form einer einzelnen Diode ausgebildet ist, dann die Anzahl der zur Realisierung der 3-Level-Stromrichterhalbbrücke benötigten Dioden reduziert werden kann.

Ausführungsbeispiele der Erfindung sind in den Figuren dargestellt und werden im Folgenden näher erläutert. Dabei zeigen:
- FIG 1: ein elektrisches Schaltbild einer techniküblichen 3-Level-Stromrichterhalbbrücke,
- FIG 2: ein elektrisches Schaltbild einer erfindungsgemäßen 3-Level-Stromrichtershalbbrücke und die erfindungsgemäße Aufteilung der Leistungshalbleiterschalter und der Dioden der erfindungsgemäßen 3-Level-Stromrichterhalbbrücke auf ein erstes und ein zweites Substrat,
- FIG 3: ein erstes Substrat einer erfindungsgemäßen 3-Level-Stromrichterhalbbrücke und den auf dem ersten Substrat angeordneten Leistungshalbleiterschalter und Dioden in Form einer schematisierten Darstellung,
- FIG 4: ein zweites Substrat einer erfindungsgemäßen 3-Level-Stromrichterhalbbrücke und den auf dem zweiten Substrat angeordneten Leistungshalbleiterschalter und Dioden in Form einer schematisierten Darstellung und
- FIG 5: ein elektrisches Schaltbild einer weiteren erfindungsgemäßen 3-Level-Stromrichterhalbbrücke und die erfindungsgemäße Aufteilung der Leistungshalbleiterschalter und der Dioden der weiteren erfindungsgemäßen 3-Level-Stromrichterhalbbrücke auf ein erstes und ein zweites Substrat.

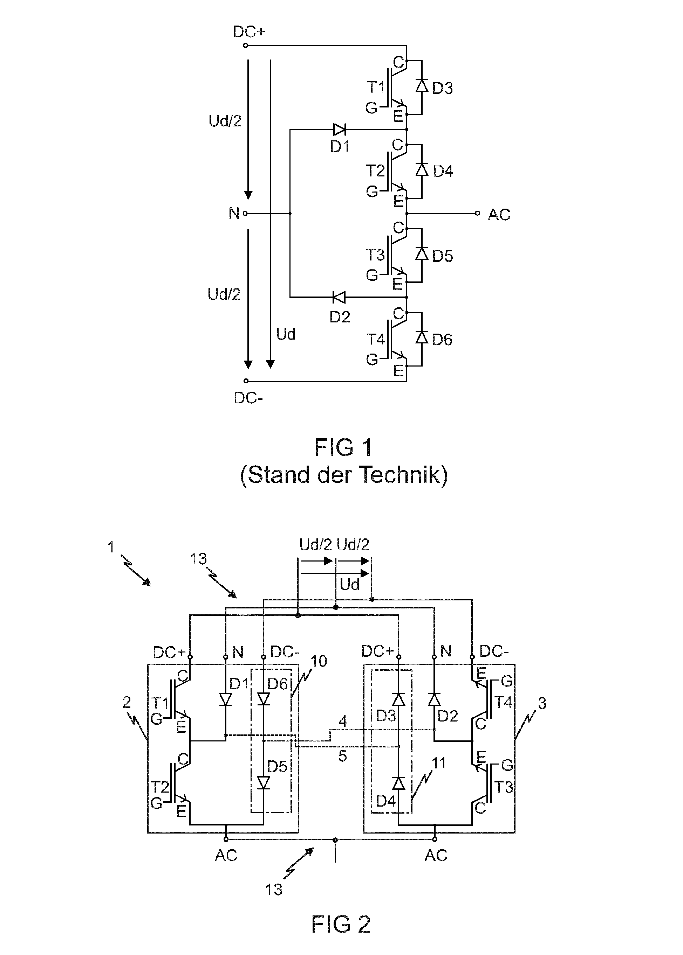

In FIG 1 ist elektrisches Schaltbild einer techniküblichen 3-Level-Stromrichterhalbbrücke dargestellt. Die 3-Level-Stromrichterhalbbrücke weist einen ersten Leistungshalbleiterschalter T1, einen zweiten Leistungshalbleiterschalter T2, einen dritten Leistungshalbleiterschalter T3, einen vierten Leistungshalbleiterschalter T4, erste Diode D1, eine zweite Diode D2, eine dritte Diode D3, eine vierte Diode D4, eine fünfte Diode D5 und eine sechste Diode D6 auf, die elektrisch, wie in FIG 1 dargestellt, zu einer sogenannten Halbbrückenschaltung verschalten sind. Die 3-Level-Stromrichterhalbbrücke wird von zwei in FIG 1 nicht dargestellten Spannungsquellen gespeist, die jeweilig die halbe Zwischenkreisspannung Ud/2 erzeugen, so das zwischen den beiden Gleichspannnungsanschlüssen DC+ und DC- die Zwischenkreisspannung Ud anliegt.

In FIG 1 sind die Leistungshalbleiterschalter als IGBT ausgebildet und können über Ihren Steuereingang G ein- und ausgeschaltet werden. Durch entsprechendes Ein- und Ausgeschalten der Leistungshalbleiterschalter können am wechselspannungsseitigen Lastanschluss AC elektrische Spannungen erzeugt werden, deren Spannungsbetragswert im Wesentlichen der elektrischen Spannung der Zwischenkreisspannung Ud oder im Wesentlichen der halben elektrischen Zwischenkreisspannung Ud/2 entsprechen, so dass bei entsprechender Ansteuerung der Leistungshalbleiterschalter entsprechende Spannungen am wechselspannungsseitigen Lastanschluss AC aus den beiden halben Zwischenkreisspannung Ud/2 bzw. aus der Zwischenkreisspannung Ud erzeugt werden. Die elektrische Funktionsweise eines 3-Level-Stromrichters ist allgemein bekannter Stand der Technik.

Es sei angemerkt, dass ein 3-Level-Stromrichter mehrere 3-Level-Stromrichterhalbbrücken aufweist. So kann der 3-Level-Stromrichter z.B. drei 3-Level-Stromrichterhalbbrücken aufweisen mittels derer, durch entsprechende Ansteuerung der Leistungshalbleiterschalter der 3-Level-Stromrichterhalbbrücken, aus den beiden halben Zwischenkreisspannung Ud/2 bzw. der Zwischenkreisspannung Ud eine 3-phasige Wechselspannung, z.B. zur Ansteuerung eines Elektromotors, erzeugt werden kann. Selbstverständlich kann ein 3-Level-Stromrichter aber auch als Gleichrichter arbeiten.

Beim allgemeinen Betrieb einer 3-Level-Stromrichterhalbbrücke gemäß FIG 1 treten beim Ein- und Ausschalten der Leistungshalbleiterschalter nur Stromkommutierungen zwischen dem ersten Leistungshalbleiterschalter T1, dem zweiten Leistungshalbleiterschalter T2, der ersten Diode D1, der fünften Diode D5 und der sechsten Diode D6, und zwischen dem dritten Leistungshalbleiterschalter T3, dem vierten Leistungshalbleiterschalter T4, der zweiten Diode D2, der dritten Diode D3 und der vierten Diode D4 auf. Der erste Leistungshalbleiterschalter T1, der zweite Leistungshalbleiterschalter T2, die erste Diode D1, die fünften Diode D5 und die sechsten Diode D6 bilden somit eine erste Kommutierungsgruppe, und der dritte Leistungshalbleiterschalter T3, der vierte Leistungshalbleiterschalter T4, die zweite Diode D2, die dritten Diode D3 und die vierten Diode D4 bilden somit eine zweite Kommutierungsgruppe. Zwischen Leistungshalbleiterschaltern und Dioden der ersten und der zweiten Kommutierungsgruppe treten keine Stromkommutierungen beim Ein- und Ausschalten der Leistungshalbleiterschalter auf.

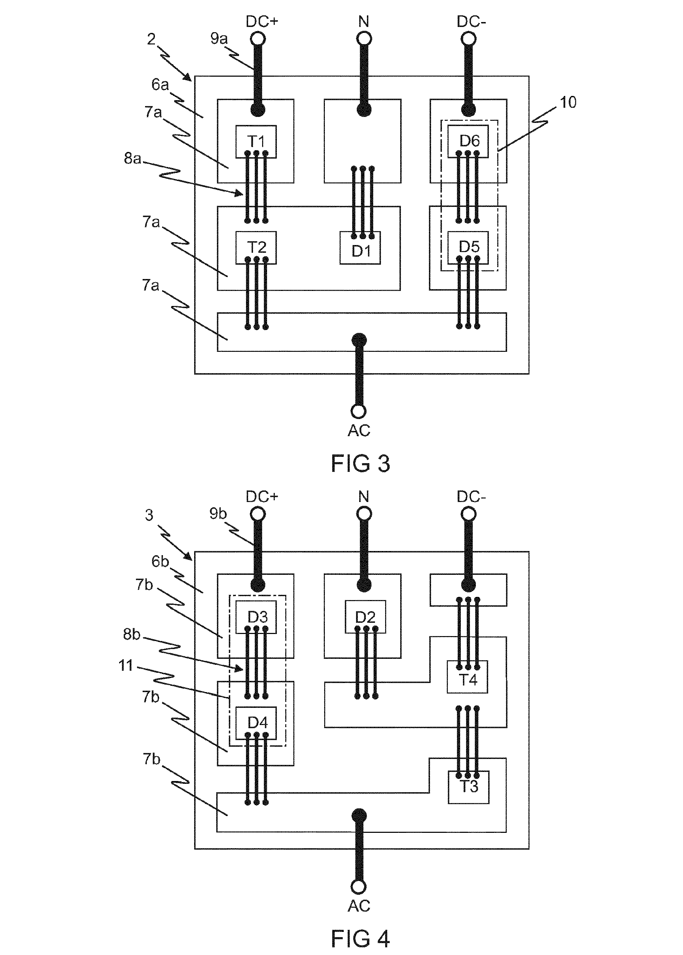

Diese technische Erkenntnis wird zur Realisierung einer erfindungsgemäßen 3-Level-Stromrichterhalbbrücke verwendet. In FIG 2 ist ein elektrisches Schaltbild einer erfindungsgemäßen 3-Level-Stromrichterhalbbrücke 1 und die erfindungsgemäße Aufteilung der Leistungshalbleiterschalter und der Dioden der erfindungsgemäßen 3-Level-Stromrichterhalbbrücke 1 auf ein erstes Substrat 2 und ein zweites Substrat 3 dargestellt. In FIG 3 ist das erste Substrat 2 des erfindungsgemäßen 3-Level-Stromrichters 1 und der auf dem ersten Substrat 2 angeordneten Leistungshalbleiterschalter und Dioden in Form einer schematisierten Darstellung dargestellt. In FIG 4 ist das zweite Substrat 3 der erfindungsgemäßen 3-Level-Stromrichterhalbbrücke 1 und der auf dem zweiten Substrat 3 angeordneten Leistungshalbleiterschalter und Dioden in Form einer schematisierten Darstellung dargestellt.

Erfindungsgemäß sind Leistungshalbleiterschalter und Dioden der ersten Kommutierungsgruppe auf dem ersten Substrat 2 und die Leistungshalbleiterschalter und Dioden der zweiten Kommutierungsgruppe auf dem zweiten Substrat 3 angeordnet. Da infolge beim Betrieb der erfindungsgemäßen 3-Level-Stromrichterhalbbrücke 1 keine Stromkommutierung zwischen den Leistungshalbleiterschaltern und Dioden welche auf dem ersten Substrat 2 angeordnet sind und den Leistungshalbleiterschaltern und Dioden welche auf dem zweiten Substrat 3 angeordnet sind, stattfindet, ist die Bedeutung der parasitären Induktivitäten der elektrischen Verbindungsleitungen, welche das erste und das zweite Substrat elektrisch leitend miteinander verbinden deutlich reduziert und infolge dessen sind die Schaltüberspannungen bei der erfindungsgemäßen 3-Level Stromrichterhalbbrücke 1 gegenüber techniküblichen 3-Level Stromrichterhalbbrücken, bei denen die Leistungshalbleiterschaltern und Dioden in anderer Form auf mehreren Substraten verteilt sind, deutlich reduziert.

Wie schon beschrieben weist die erfindungsgemäße 3-Level Stromrichterhalbbrücke 1 ein erstes Substrat 2 und ein vom ersten Substrat 2 getrennt angeordnetes zweites Substrat 3 auf. Das erste und das zweite Substrat 2 und 3 können in einem gemeinsamen Gehäuse oder in zwei voneinander getrennten Gehäusen angeordnet sein. Das erste Substrat 2 weist einen ersten Isolierstoffkörper 6a und eine auf dem ersten Isolierstoffkörper 6a angeordnete elektrisch leitende strukturierte erste Leitungsschicht auf, die infolge ihrer Struktur elektrische Leiterbahnen ausbildet, wobei der Übersichtlichkeit halber in FIG 3 nur drei Leiterbahnen 7a mit einem Bezugszeichen versehen sind. Vorzugsweise weist das erste Substrat 2 eine weitere elektrisch leitende, vorzugsweise unstrukturierte Leitungsschicht auf, wobei der Isolierstoffkörper 6a zwischen der strukturierten ersten Leitungsschicht und der weiteren Leitungsschicht angeordnet ist. An der weiteren Leitungsschicht des ersten Substrats 2 ist im Allgemeinen ein Kühlkörper, der zur Kühlung der auf dem ersten Substrat 2 angeordneten Elemente dient, angeordnet. Die weitere Leitungsschicht des ersten Substrats 2 ist in der in FIG 3 dargestellten Ansicht nicht sichtbar auf der Rückseite des ersten Isolierstoffkörpers 6 angeordnet. Die strukturierte erste Leitungsschicht des ersten Substrats 2 kann z.B. aus Kupfer bestehen. Das erste Substrat kann z.B. in Form eines DCB-Substrats oder in Form eines Insulated Metal Substrats vorliegen. Im Falle eines DCB-Substrat kann der erste Isolierstoffkörper 6a z.B. aus einer Keramik bestehen und die weitere Leitungsschicht des ersten Substrats aus Kupfer bestehen. Im Falle eines Insulated Metal Substrats kann der erste Isolierstoffkörper 6a z.B. aus einer Schicht aus Polyimid oder Epoxy bestehen und die weitere Leitungsschicht des ersten Substrats aus einem Metallformkörper bestehen. Der Metallformkörper kann z.B. aus Aluminium oder einer Aluminiumlegierung bestehen.

Das zweite Substrat 3 weist einen zweiten Isolierstoffkörper 6b und eine auf dem zweiten Isolierstoffkörper 6b angeordnete elektrisch leitende strukturierte zweite Leitungsschicht auf, die infolge ihrer Struktur elektrische Leiterbahnen ausbildet, wobei der Übersichtlichkeit halber in FIG 4 nur drei Leiterbahnen 7b mit einem Bezugszeichen versehen sind. Vorzugsweise weist das zweite Substrat 3 eine weitere elektrisch leitende, vorzugsweise unstrukturierte Leitungsschicht auf, wobei der Isolierstoffkörper 6b zwischen der strukturierten ersten Leitungsschicht und der weiteren Leitungsschicht angeordnet ist. An der weiteren Leitungsschicht des zweiten Substrats 3 ist im Allgemeinen ein Kühlkörper, der zur Kühlung der auf dem zweiten Substrat 3 angeordneten Elemente dient, angeordnet. Die weitere Leitungsschicht des zweiten Substrats 3 ist in der in FIG 3 dargestellten Ansicht nicht sichtbar auf der Rückseite des zweiten Isolierstoffkörpers 6b angeordnet. Die strukturierte zweite Leitungsschicht des zweiten Substrats 3 kann z.B. aus Kupfer bestehen. Das zweite Substrat kann z.B. in Form eines DCB-Substrats oder in Form eines Insulated Metal Substrats vorliegen. Im Falle eines DCB-Substrat kann der zweite Isolierstoffkörper 6b z.B. aus einer Keramik bestehen und die weitere Leitungsschicht des zweiten Substrats aus Kupfer bestehen. Im Falle eines Insulated Metal Substrats Substrat kann der zweite Isolierstoffkörper 6b z.B. aus einer Schicht aus Polyimid oder Epoxy bestehen und die weitere Leitungsschicht des zweiten Substrats aus einem Metallformkörper bestehen. Der Metallformkörper kann z.B. aus Aluminium oder einer Aluminiumlegierung bestehen.

Auf der strukturierten ersten Leitungsschicht des ersten Substrats 2 sind ein erster Leistungshalbleiterschalter T1, ein zweiter Leistungshalbleiterschalter T2, eine erste Diode D1 und eine erste Diodenanordnung 10 angeordnet und mit der strukturierten ersten Leitungsschicht verbunden. Im Rahmen des in den Figuren 2 bis 4 dargestellten Ausführungsbeispiels weist die erste Diodenanordnung 10 eine fünfte und eine sechse Diode D5 und D6 auf, wobei die Kathode der sechsten Diode D6 mit der Anode der fünften Diode D5, beim Ausführungsbeispiel über Bonddrähte, elektrisch leitend verbunden ist. Der Übersichtlichkeit halber sind in FIG 3 nur drei Bonddrähte 8a mit einem Bezugszeichen versehen. Der erste Leistungshalbleiterschalter T1, der zweite Leistungshalbleiterschalter T2, die erste Diode D1 und die fünfte und die sechse Diode D5 und D6 weisen an Ihrer dem ersten Substrat 2 zugewandten Seite einen elektrischen Laststromanschluss auf, der z.B. über eine Schweiß-, Löt- oder Sinterverbindung mit einer jeweilig zugeordneten Leiterbahn 7a verbunden ist und an ihrer dem ersten Substrat 2 abgewandten Seite einen elektrischen Laststromanschluss auf, der beim Ausführungsbeispiel über Bonddrähte mit einer jeweilig zugeordneten Leiterbahn verbunden ist.

Auf der strukturierten zweiten Leitungsschicht des zweiten Substrats 3 sind ein dritter Leistungshalbleiterschalter T3, ein vierter Leistungshalbleiterschalter T4, eine zweite Diode D2 und eine zweite Diodenanordnung 11 angeordnet und mit der strukturierten zweiten Leitungsschicht verbunden. Im Rahmen des in den Figuren 2 bis 4 dargestellten Ausführungsbeispiels weist die zweite Diodenanordnung 11 eine dritte und eine vierte Diode D3 und D4 auf, wobei die Kathode der vierten Diode D4 mit der Anode der dritten Diode D3, beim Ausführungsbeispiel über Bonddrähte, elektrisch leitend verbunden ist. Der Übersichtlichkeit halber sind in FIG 4 nur drei Bonddrähte 8b mit einem Bezugszeichen versehen. Der dritte Leistungshalbleiterschalter T3, der vierte Leistungshalbleiterschalter T4, die zweite Diode D2 und die dritte und vierte Diode D3 und D4 weisen an Ihrer dem zweiten Substrat 3 zugewandten Seite einen elektrischen Laststromanschluss auf, der z.B. über eine Schweiß-, Löt- oder Sinterverbindung mit einer jeweilig zugeordneten Leiterbahn 7b verbunden ist und an ihrer dem zweiten Substrat 3 abgewandten Seite einen elektrischen Laststromanschluss auf, der beim Ausführungsbeispiel über Bonddrähte mit einer jeweilig zugeordneten Leiterbahn verbunden ist.

Anstatt über Bonddrähte können die betreffenden Elemente auch über andere elektrische Verbindungsmittel miteinander elektrisch leitend verbunden sein.

Der zweite Laststromanschluss E des ersten Leistungshalbleiterschalters T1 ist mit dem ersten Laststromanschluss C des zweiten Leistungshalbleiterschalter T2 elektrisch leitend verbunden. Weiterhin ist der erste Laststromanschluss C des vierten Leistungshalbleiterschalters T4 mit einem zweiten Laststromanschluss E des dritten Leistungshalbleiterschalter T3 elektrisch leitend verbunden.

Die Kathode der ersten Diode D1 ist mit dem zweiten Laststromanschluss E des ersten Leistungshalbleiterschalters T1 elektrisch leitend verbunden und die Anode der zweiten Diode D2 ist mit dem zweiten Laststromanschluss E des dritten Leistungshalbleiterschalters T3 elektrisch leitend verbunden. Weiterhin ist der zweite Laststromanschluss E des zweiten Leistungshalbleiterschalters T2 mit dem Kathodenanschluss der ersten Diodenanordnung 10 elektrisch leitend verbunden, wobei der Kathodenanschluss der ersten Diodenanordnung 10, bei diesem Ausführungsbeispiel der Erfindung, durch die Kathode der fünften Diode D5 gebildet wird.

Weiterhin ist der erste Laststromanschluss C des dritten Leistungshalbleiterschalters T3 mit einem Anodenanschluss der zweiten Diodenanordnung 11 elektrisch leitend verbunden, wobei bei diesem Ausführungsbeispiel der Erfindung, der Anodenanschluss der zweiten Diodenanordnung 11 durch die Anode der vierten Diode D4 gebildet wird.

Der erste Laststromanschluss C des ersten Leistungshalbleiterschalters T1 ist mit einem Kathodenanschluss der zweiten Diodenanordnung 11 elektrisch leitend verbunden, wobei bei diesem Ausführungsbeispiel der Erfindung, der Kathodenanschluss der zweiten Diodenanordnung 11 durch die Kathode der dritten Diode D3 gebildet wird. Weiterhin ist der zweite Laststromanschluss E des vierten Leistungshalbleiterschalters T4 mit dem Anodenanschluss der ersten Diodenanordnung 10 elektrisch leitend verbunden, wobei bei diesem Ausführungsbeispiel der Erfindung, der Anodenanschluss der ersten Diodenanordnung 10 durch die Anode der sechsten Diode D6 gebildet wird.

Weiterhin ist die Anode der ersten Diode D1 ist mit der Kathode der zweiten Diode D2 elektrisch leitend verbunden und der zweite Laststromanschluss E des zweiten Leistungshalbleiterschalters T2 ist mit dem ersten Laststromanschluss C des dritten Leistungshalbleiterschalters T3 elektrisch leitend verbunden.

Im Rahmen des Ausführungsbeispiels werden über Lastanschlusselemente die mit dem ersten oder zweiten dem Substrat verbunden sind, das erste und das zweite Substrat über Kabel und/oder Stromschienen 13 miteinander elektrisch leitend verbunden. Der Übersichtlichkeit halber sind in FIG 3 und FIG 4 nur die beiden Lastanschlusselemente 9a und 9b mit einem Bezugszeichen versehen.

Bei der erfindungsgemäßen 3-Level-Stromrichterhalbbrücke 1 sind die in FIG 2 gestrichelt dargestellten elektrischen leitenden Verbindungen 4 und 5 nicht notwendig und können entfallen. Die Kathode der ersten Diode D1 ist folglich mit der Kathode der vierten Diode D4 vorzugsweise nicht elektrisch leitend verbunden und die Kathode der sechsten Diode D6 ist mit der Anode der zweiten Diode D2 vorzugsweise nicht elektrisch leitend verbunden.

Es sei an dieser Stelle angemerkt, das im Rahmen des Ausführungsbeispiels die Leistungshalbleiterschalter in Form von IGBTs vorliegen und der erste Laststromanschluss C des jeweiligen Leistungshalbleiterschalters in Form des Kollektors des jeweiligen IGBT und der zweite Laststromanschluss E des jeweiligen Leistungshalbleiterschalters in Form des Emitters des jeweiligen IGBT vorliegt. Der Steueranschluss G der Leistungshalbleiterschalter ist der Übersichtlichkeit halber in FIG 3 und FIG 4 nicht dargestellt und liegt beim Ausführungsbeispiels in Form des Gate des jeweiligen IGBT vor.

Es sei an dieser Stelle weiterhin angemerkt, dass im Sinne der vorliegenden Erfindung unter dem Ausdruck, dass zwei Elemente elektrisch leitend verbunden sind, sowohl eine direkte elektrisch leitende Verbindung von zwei Elementen, mittels z.B. einer Schweiß-, Löt- oder Sinterverbindung, die zwischen den beiden Elementen angeordnet ist, als auch eine indirekte elektrisch leitende Verbindung, mittels z.B. einem oder mehreren Leitungselementen, wie z.B. einer Leiterbahn, einem Bonddraht, einem elektrisch leitenden Folienverbund, einer Stromschiene oder einem Kabel, die die beiden Elemente elektrisch miteinander verbinden, so dass eine elektrischer Stromfluss zwischen den beiden elektrisch miteinander leitend verbunden Elementen möglich ist, verstanden wird.

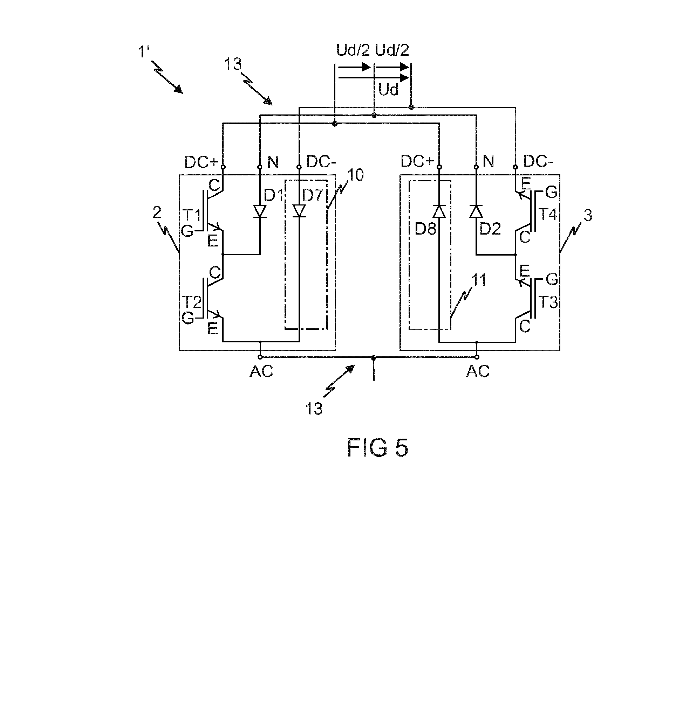

In FIG 5 ist ein elektrisches Schaltbild einer weiteren erfindungsgemäßen 3-Level Stromrichterhalbbrücke 1' und die erfindungsgemäße Aufteilung der Leistungshalbleiterschalter und der Dioden der weiteren erfindungsgemäßen 3-Level Stromrichterhalbbrücke 1' auf ein erstes und ein zweites Substrat 2 und 3 dargestellt. Die 3-Level Stromrichterhalbbrücke 1' entspricht dabei in der Funktion und im Aufbau der 3-Level Stromrichterhalbbrücke 1 gemäß der Figuren 2 bis 4 mit dem Unterschied, dass die erste Diodenanordnung 10 in Form einer einzelnen Diode ausgebildet ist, die nachfolgend als siebte Diode D7 bezeichnet wird und die zweite Diodenanordnung 11 in Form einer einzelnen Diode ausgebildet ist, die nachfolgend als achte Diode D8 bezeichnet wird. Bei diesem Ausführungsbeispiel der Erfindung sind die fünfte und die sechste Diode D5 und D6 zu der siebten Diode D7 zusammengefasst, und die dritte und die vierte Diode D3 und D4 zu der achten Diode D8 zusammengefasst.

Durch diese Maßnahme kann die Anzahl der zur Realisierung der 3-Level-Stromrichterhalbbrücke benötigten Dioden reduziert werden und somit die 3-Level-Stromrichterhalbbrücke 1' gegenüber der 3-Level-Stromrichterhalbbrücke 1 kleiner gebaut werden.

Vorzugsweise sollte dabei die siebte und die achte Diode D7 und D8 gegenüber der dritten, vierten, fünften und sechsten Diode eine höhere Sperrspannung aufweisen.

Es sei an dieser Stelle angemerkt, dass gegebenenfalls zur Erhöhung der Stromtragefähigkeit der erfindungsgemäßen 3-Level-Stromrichterhalbbrücke den Leistungshalbleiterschaltern jeweilig noch ein oder mehrere Leistungshalbleiterschalter elektrisch parallel geschaltet sein können.

## Patentansprüche

1. 3-Level-Stromrichterhalbbrücke mit einem ersten Substrat (2) und einem vom ersten Substrat (2) getrennt angeordneten zweiten Substrat (3),
wobei das erste Substrat (2) einen ersten Isolierstoffkörper (6a) und eine auf dem ersten Isolierstoffkörper (6a) angeordnete elektrisch leitende strukturierte erste Leitungsschicht (7a) aufweist, wobei auf der strukturierten ersten Leitungsschicht (7a) ein erster Leistungshalbleiterschalter (T1), ein zweiter Leistungshalbleiterschalter (T2), eine erste Diode (D1) und eine erste Diodenanordnung (10) angeordnet sind und mit der strukturierten ersten Leitungsschicht (7a) verbunden sind,
wobei das zweite Substrat (3) einen zweiten Isolierstoffkörper (6b) und eine auf dem zweiten Isolierstoffkörper (6b) angeordnete elektrisch leitende strukturierte zweite Leitungsschicht (7b) aufweist,
wobei auf der strukturierten zweiten Leitungsschicht (7b) ein dritter Leistungshalbleiterschalter (T3), ein vierter Leistungshalbleiterschalter (T4), eine zweite Diode (D2) und eine zweite Diodenanordnung (11) angeordnet sind und mit der strukturierten zweiten Leitungsschicht (7b) verbunden sind,
wobei ein zweiter Laststromanschluss (E) des ersten Leistungshalbleiterschalters (T1) mit einem ersten Laststromanschluss (C) des zweiten Leistungshalbleiterschalter (T2) elektrisch leitend verbunden ist, wobei ein erster Laststromanschluss (C) des vierten Leistungshalbleiterschalters (T4) mit einem zweiten Laststromanschluss (E) des dritten Leistungshalbleiterschalter (T3) elektrisch leitend verbunden ist,
wobei die Kathode der ersten Diode (D1) mit dem zweiten Laststromanschluss (E) des ersten Leistungshalbleiterschalters (T1) elektrisch leitend verbunden ist, wobei die Anode der zweiten Diode (D2) mit dem zweiten Laststromanschluss (E) des dritten Leistungshalbleiterschalters (T3) elektrisch leitend verbunden ist, wobei der zweiter Laststromanschluss (E) des zweiten Leistungshalbleiterschalters (T2) mit einem Kathodenanschluss der ersten Diodenanordnung (10) elektrisch leitend verbunden ist,
wobei der erste Laststromanschluss (C) des dritten Leistungshalbleiterschalters (T3) mit einem Anodenanschluss der zweiten Diodenanordnung (11) elektrisch leitend verbunden ist,
wobei der erste Laststromanschluss (C) des ersten Leistungshalbleiterschalters (T1) mit einem Kathodenanschluss der zweiten Diodenanordnung (11) elektrisch leitend verbunden ist,
wobei der zweite Laststromanschluss (E) des vierten Leistungshalbleiterschalters (T4) mit einem Anodenanschluss der ersten Diodenanordnung (10) elektrisch leitend verbunden ist,
wobei die Anode der ersten Diode (D1) mit der Kathode der zweiten Diode (D2) elektrisch leitend verbunden ist,
wobei der zweite Laststromanschluss (E) des zweiten Leistungshalbleiterschalters (T2) mit dem ersten Laststromanschluss (C) des dritten Leistungshalbleiterschalters (T3) elektrisch leitend verbunden ist.

2. 3-Level-Stromrichterhalbbrücke nach Anspruch 1, **dadurch gekennzeichnet, dass** die erste Diodenanordnung (10) eine fünfte und eine sechse Diode (D5,D6) aufweist, wobei die Kathode der sechsten Diode (D6) mit der Anode der fünften Diode (D5) elektrisch leitend verbunden ist, und dass die zweite Diodenanordnung (11) eine dritte und eine vierte Diode (D3,D4) aufweist, wobei die Kathode der vierten Diode (D4) mit der Anode der dritten Diode (D3) elektrisch leitend verbunden ist.

3. 3-Level-Stromrichterhalbbrücke nach Anspruch 2, **dadurch gekennzeichnet, dass** die Kathode der ersten Diode (D1) mit der Kathode der vierten Diode (D4) nicht elektrisch leitend verbunden ist und die Kathode der sechsten Diode (D6) mit der Anode der zweiten Diode (D2) nicht elektrisch leitend verbunden ist.

4. 3-Level-Stromrichterhalbbrücke nach Anspruch 1, **dadurch gekennzeichnet, dass** die erste Diodenanordnung (10) in Form einer einzelnen Diode (D7) ausgebildet ist und die zweite Diodenanordnung in Form einer einzelnen Diode (D8) ausgebildet ist.
